# EUROPÄISCHE PATENTANMELDUNG

(11) **EP 2 275 870 A1**
(43) Veröffentlichungstag der Anmeldung: **19.01.2011**
(21) Anmeldenummer: 09165434.3
(22) Anmeldetag: 14.07.2009
(51) Int. Cl.: G03F 7/24, G03F 1/00

(54) **Verfahren zum Herstellen von zylinderförmigen Flexodruckplatten mittels digitaler Bebilderung**

(71) Anmelder: Flint Group Germany GmbH, 70469 Stuttgart (DE)
(72) Erfinder: Isselhard, Thomas, 70569, Stuttgart (DE); Dietz, Gernot, 67304, Eisenberg (DE); Stebani, Uwe, 67592, Flörsheim-Dalsheim (DE)
(74) Vertreter: Schuck, Alexander

(57) **Zusammenfassung**

Verfahren zur Herstellung einer zylinderförmigen Flexodruckform umfassend auf einem zylinderförmigen Sleeve eine oder mehrere einzelne, voneinander beabstandete Flexodruckplatten, mit den Schritten:
(a) Bereitstellen eines Sleeves, auf dem eine oder mehrere einzelne fotopolymerisierbare Flexodruckelemente derart aufgebracht sind, dass zwischen den Kanten des oder der Flexodruckelemente Zwischenräume verbleiben, wobei das oder die Flexodruckelemente als oberste Schicht eine aktinisches Licht absorbierende, laserablatierbare Schicht aufweisen,
(b) Einschreiben einer Maske mittels eines IR-Lasers in die laserablatierbare Schicht der fotopolymerisierbaren Flexodruckelemente,
(c) Belichten der Flexodruckelemente durch die eingeschriebene Maske hindurch mit aktinischem Licht,
(d) Entfernen der nicht vernetzten, unbelichteten Bereiche der Flexodruckelemente und der Reste der laserablatierbaren Schicht,
**dadurch gekennzeichnet, dass** der in Schritt (a) bereitgestellte Sleeve mit den Flexodruckelementen hergestellt wird durch
(a1) Aufbringen eines oder mehrerer fotopolymerisierbarer Flexodruckelemente, wobei die Flexodruckelemente keine laserablatierbare Schicht aufweisen, auf den Sleeve derart, dass zwischen den Kanten des oder der Flexodruckelemente Zwischenräume verbleiben,
(a2) Aufsprühen der laserablatierbaren Schicht, enthaltend ein Lösemittel, ein darin gelöstes Bindemittel sowie mindestens einen Absorber oder ein Absorbergemisch für IR-Licht und aktinisches Licht, auf das oder die fotopolymerisierbaren Flexodruckelemente, wobei die Kanten der Flexodruckelemente von der laserablatierbaren Schicht bedeckt werden,
(a3) Trocknen der laserablatierbaren Schicht.

## Beschreibung

Die vorliegende Erfindung betrifft ein Verfahren zum Herstellen von zylinderförmigen Flexodruckformen, bei denen eine oder mehrere einzelne Flexodruckplatten, welche mit einer digital bebilderbaren, laserablatierbaren Schicht versehen sind, auf einem Sleeve von einander beabstandet montiert sind, digital bebildert und zu Flexodruckformen verarbeitet werden.

Beim flexographischen Drucken können die eingesetzten Flexodruckplatten prinzipiell direkt auf dem Druckzylinder aufgebracht werden, beispielsweise indem man sie mit doppelseitigem Klebeband auf den Druckzylinder aufklebt.

Um einen schnellen Druckplattenwechsel zu ermöglichen, ist jedoch die Verwendung so genannter Sleeves üblich. Bei einem Sleeve handelt es sich um einen zylindrischen Hohlkörper, der vollständig mit einer Druckschicht umhüllt sein kann (so genannte "Endlos-nahtlos-Sleeves") oder auf den eine oder mehrere einzelne Flexodruckplatten aufgeklebt sein können (so genannte "Plate-on-Sleeve-Technologie").

Die Sleeve-Technik ermöglicht einen sehr schnellen und einfachen Wechsel der Druckform. Der Innendurchmesser der Sleeves entspricht nahezu dem Außendurchmesser des Druckzylinders, so dass die Sleeves einfach über den Druckzylinder der Druckmaschine geschoben werden können. Das Auf- und Abschieben der Sleeves funktioniert fast ausnahmslos nach dem Luftkissenprinzip: Für die Sleeve-Technologie ist die Druckmaschine mit einem speziellen Druckzylinder, einem so genannten Luftzylinder, ausgestattet. Der Luftzylinder verfügt über einen Druckluftanschluss an der Stirnseite, mit dem Druckluft in das Innere des Zylinders geleitet werden kann. Von dort aus kann sie über an der Außenseite des Zylinders angeordnete Löcher wieder austreten. Zur Montage eines Sleeves wird Druckluft in den Luftzylinder eingeleitet und tritt an den Austrittslöchern wieder aus. Der Sleeve kann nun auf den Luftzylinder aufgeschoben werden, weil er sich unter dem Einfluss des Luftkissens geringfügig dehnt und das Luftkissen die Reibung deutlich vermindert. Wenn die Druckluftzufuhr abgeschaltet wird, geht die Dehnung zurück und der Sleeve sitzt auf der Oberfläche des Luftzylinders fest. Weitere Einzelheiten zur Sleeve-Technik sind beispielsweise in "Technik des Flexodrucks", S. 73 ff., Coating Verlag, St. Gallen, 1999 offenbart.

Die Plate-on-Sleeve-Technologie eignet sich insbesondere zum Druck von Einzelmotiven. Ein typisches Beispiel hierzu sind Verpackungen bzw. Folien zur Herstellung von Verpackungen. Hierbei werden auf breiten Druckmaschinen in der Regel mehrere Motive nebeneinander gedruckt. Ein Sleeve für eine derartige Anwendung weist dementsprechend mehrere nebeneinander auf dem Sleeve aufgebrachte Flexodruckplatten auf, die jeweils durch einen Zwischenraum voneinander getrennt sind.

Die Herstellung von Flexodruckformen kann erfolgen, indem man ein fotopolymerisierbares Flexodruckelement als Ausgangsmaterial einsetzt und dieses bildweise belichtet, wobei die belichteten Stellen fotochemisch vernetzen. Die unbelichteten Stellen werden anschließend mit einem geeigneten Lösemittel ausgewaschen oder thermisch entfernt. Zum bildweisen Belichten kann man auf das Flexodruckelement eine fotografisch hergestellte Maske auflegen. Moderne Flexodruckelemente weisen häufig eine Lasermaske auf. Hierbei handelt es sich um eine UV-undurchlässige, laserablatierbare Schicht, beispielsweise eine Schicht aus Ruß und einem geeigneten polymeren Bindemittel, welche als oberste Schicht auf das Flexodruckelement aufgebracht ist. Mithilfe eines Lasers kann ein Bild in die Schicht eingeschrieben werden, d.h. die Teile der Maske, die vom Laserstrahl getroffen werden, verdampfen. Durch die so gebildete Maske kann anschließend belichtet werden kann. Derartige Flexodruckelemente sind beispielsweise in DE 195 36 805 oder US 5,262,275 beschrieben.

Bei der Herstellung von Sleeves, welche mehrere einzelne Flexodruckplatten aufweisen, kann man bereits vorgefertigte Flexodruckplatten registergerecht auf einen Sleeve montieren. Eine derartige registergerechte Montage ist aber sehr aufwändig. Es ist daher bekannt, fotopolymerisierbare, laserablatierbare Schichten aufweisende Flexodruckelemente auf den Sleeve zu montieren, wobei es ausreichend ist, dass diese etwa an der richtigen Stelle montiert werden, ohne dass es hierbei auf absolute Präzision ankommt. Die aufgebrachten Flexodruckelemente werden einer Laserapparatur registergerecht bebildert, so dass weitere Maßnahmen zu Registrierung nicht erforderlich sind. Die Sleeves einschließlich der einzelnen, darauf aufgebrachten Flexodruckelemente werden anschließend mit aktinischem Licht belichtet und mittels Lösemitteln oder thermisch entwickelt.

Ein Problem beim Belichten derartiger Sleeves ist der Schutz der Kanten der aufgebrachten Flexodruckelemente. Die laserablatierbare Schicht bedeckt nur die Oberseite der eingesetzten, fotopolymerisierbaren Flexodruckelemente, während die Kanten nicht davon bedeckt sind. Dies liegt daran, dass die verwendeten Flexodruckelemente zum Einsatz ausgehend von größeren Stücken zurechtgeschnitten werden. Beim Belichten der Sleeves kann deswegen auch Licht von der Seite in die fotopolymerisierbare Schicht eindringen und die Schicht an den Kanten von der Seite her polymerisieren. Hierdurch werden entlang der Kanten das Druckbild störende Stege gebildet. Das nachträgliche Abschneiden dieser Stege ist kaum möglich, da die Platten bereits registergerecht auf dem Sleeve montiert sind, und die Gefahr, dass die Druckform dadurch beschädigt werden könnte, sehr groß ist. Außerdem ist das nachträgliche Abschneiden sehr aufwändig.

Es ist daher üblich, die ungeschützten Kanten vor dem Belichten zu schützen. Dies kann beispielsweise erfolgen, indem man die Kanten mit einem für UV-Strahlung undurchlässigen Klebeband abklebt. EP 863 435 A1 schlägt vor, die Kanten mit einem Kantenabdeckmaterial, welches mindestens ein Lösemittel, ein darin lösliches Bindemittel sowie einen UV-Absorber enthält, abzudecken. Das nachträgliche Abdecken ungeschützter Kanten ist aber sehr zeitaufwändig, weil es mittels Handarbeit erfolgen muss, und nimmt mit zunehmender Anzahl aufgebrachter Flexodruckelemente naturgemäß zu. Die bereits zitierte Schrift EP 863 435 A1 schlägt beispielsweise vor, die die Kanten schützende Lösung mit einer Pipette auf die Kanten aufzutragen. Das Aufsprühen der Lösung ist nicht problemlos möglich. Wird nämlich die Formulierung zum Kantenabdecken auch auf die Oberfläche gesprüht, wird die laserablatierbare Schicht mit einer zusätzlichen Schicht aus dem Kantenschutzmaterial versehen. An diesen Stellen wird dementsprechend die Empfindlichkeit der laserablatierbaren Schicht gegenüber Laserstrahlung deutlich herabgesetzt. In diesen Bereichen wird möglicherweise nur unvollständig ablatiert und eine unbrauchbare Druckplatte erhalten. Will man dies berücksichtigen, muss man deutlich langsamer ablatieren, was zu einer verringerten Wirtschaftlichkeit des Prozesses führt.

Aufgabe der Erfindung war es, ein wirtschaftlicheres Verfahren zur Herstellung von Sleeves für die Plate-on-sleeve-Technologie bereitzustellen.

Gelöst wird die Aufgabe durch ein Verfahren zur Herstellung einer zylinderförmigen Flexodruckform umfassend auf einem zylinderförmigen Sleeve eine oder mehrere einzelne, voneinander beabstandete Flexodruckplatten, mit den Schritten:
(a) Bereitstellen eines Sleeves, auf dem eine oder mehrere einzelne fotopolymerisierbare Flexodruckelemente derart aufgebracht sind, dass zwischen den Kanten des oder der Flexodruckelemente Zwischenräume verbleiben, wobei das oder die Flexodruckelemente als oberste Schicht eine aktinisches Licht absorbierende, laserablatierbare Schicht aufweisen,
(b) Einschreiben einer Maske mittels eines IR-Lasers in die laserablatierbare Schicht der fotopolymerisierbaren Flexodruckelemente,
(c) Belichten der Flexodruckelemente durch die eingeschriebene Maske hindurch mit aktinischem Licht,
(d) Entfernen der nicht vernetzten, unbelichteten Bereiche der Flexodruckelemente und der Reste der laserablatierbaren Schicht,
**dadurch gekennzeichnet, dass** der in Schritt (a) bereitgestellte Sleeve mit den Flexodruckelementen hergestellt wird durch
(a1) Aufbringen eines oder mehrerer fotopolymerisierbarer Flexodruckelemente, wobei die Flexodruckelemente keine laserablatierbare Schicht aufweisen, auf den Sleeve derart, dass zwischen den Kanten des oder der Flexodruckelemente Zwischenräume verbleiben,
(a2) Aufsprühen der laserablatierbaren Schicht, enthaltend ein Lösemittel, ein darin gelöstes Bindemittel sowie mindestens einen Absorber oder ein Absorbergemisch für IR-Licht und aktinisches Licht, auf das oder die fotopolymerisierbaren Flexodruckelemente, wobei die Kanten der Flexodruckelemente von der laserablatierbaren Schicht bedeckt werden,
(a3) Trocknen der laserablatierbaren Schicht.

Durch das Aufsprühen der laserablatierbaren Schicht auf die bereits zurechtgeschnittenen, auf den Sleeve aufgebrachten Flexodruckelemente werden die Kanten der Flexodruckelemente automatisch mit abgedeckt, ohne dass es hierfür aufwändiger zusätzlicher Arbeitsschritte bedarf. Durch die abgedeckten Kanten kann im Belichtungsschritt kein aktinisches Licht eindringen und die Schicht von der Seite her polymerisieren. Es werden entlang der Kanten keine das Druckbild störende Stege gebildet.

Als Träger für die fotopolymerisierbaren Flexodruckelemente können die üblichen, kommerziell erhältlichen hohlzylinderförmigen Träger verwendet werden. Diese werden in der Regel auch als Sleeves bezeichnet; der Begriff "Sleeve" wird von der Fachwelt meist in einem doppelten Sinne sowohl für die Trägerhülsen ohne fotopolymerisierbare Schicht wie auch für Trägerhülsen mit fotopolymerisierbarer Schicht verwendet. Sie bestehen in der Regel aus polymeren Materialien und weisen einen mehrschichtigen Aufbau auf. Sleeves können beispielsweise eine hohlzylinderförmige Basis aus einem faserverstärkten polymeren Material aufweisen, auf der eine kompressible Schicht gefolgt von einer Schicht aus einem harten polymeren Material angeordnet sind. Über die Dicke der Schicht aus dem harten polymeren Material lässt sich die gewünschte Drucklänge einstellen. Selbstverständlich können für das Verfahren aber auch anders aufgebaute Sleeves eingesetzt werden.

Auf die Sleeves werden in einem ersten Verfahrensschritt (a1) ein oder mehrere einzelne fotopolymerisierbare Flexodruckelemente aufgebracht.

Der Begriff "einzelne" Flexodruckelemente soll zur Unterscheidung von zu einer endlos-nahtlos Beschichtung des Sleeves über den gesamten Umfang verwendet werden. Es soll also nicht die gesamte Oberfläche des Sleeves mit einer einzigen Fotopolymerschicht bedeckt sein, sondern in der fotopolymerisierbaren Schicht sollen noch Zwischenräume und damit ungeschützte Kanten verbleiben. Es kann sich im einfachsten Fall um ein einzelnes Flexodruckelement handeln, in der Regel handelt es sich aber um mehrere Flexodruckelemente, die auf den Sleeve aufgebracht werden. Mehrere Flexodruckplatten sind also voneinander beabstandet, wobei Zwischenräume zwischen den Kanten verbleiben, bei einer einzelnen Flexodruckplatte stoßen die Kanten nicht aneinander, sondern es verbleibt ein Zwischenraum.

Bei den fotopolymerisierbaren Flexodruckelementen kann es sich um übliche fotopolymerisierbare Flexodruckelemente handeln, welche eine fotopolymerisierbare Schicht auf einem flexiblen, dimensionsstabilen Träger aufweisen. Bei flexiblen, dimensionsstabilen Trägern kann es sich beispielsweise um PET-Folien, PEN-Folien oder Polyaramidfolien handeln. Die fotopolymerisierbaren Schichten umfassen in der Regel elastomere Bindemittel, beispielsweise Styrol-Butadien- oder Styrol-Isopren-Blockcopolymere, ethylenisch ungesättigte Monomere, Fotoinitiatoren sowie optional weitere Hilfsstoffe wie Weichmacher, Farbstoffe oder thermische Stabilisatoren. Zusammensetzungen fotopolymerisierbarer Schichten von Flexodruckelementen sind dem Fachmann bekannt, und er trifft je nach den gewünschten Eigenschaften der Flexodruckform eine geeignete Auswahl. Durch die Zusammensetzung lässt sich beispielsweise die Härte der Platte bestimmen.

Die thermoplastisch-elastomeren Blockcopolymere umfassen in der Regel mindestens einen Block, welcher im Wesentlichen aus Alkenylaromaten besteht und mindestens einen Block, welcher im Wesentlichen aus 1,3-Dienen besteht. Bei den Alkenylaromaten kann es sich beispielsweise um Styrol, α-Methylstyrol oder Vinyltoluol handeln. Bevorzugt handelt es sich um Styrol. Bei den 1,3-Dienen handelt es sich bevorzugt um Butadien und/oder Isopren. Bei diesen Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock. Selbstverständlich können auch Gemische mehrerer thermoplastisch-elastomerer Bindemittel eingesetzt werden, vorausgesetzt, die Eigenschaften der reliefbildenden Schicht werden dadurch nicht negativ beeinflusst.

In einer bevorzugten Ausführungsform der Erfindung handelt es sich bei den thermoplastisch elastomeren Bindemitteln um mindestens ein Styrol-Isopren-Blockcopolymeres, insbesondere Styrol-Isopren-Styrol-Blockcopolymere, wobei die Polymere auch noch Anteile von Zweiblockcopolymeren Styrol-Isopren enthalten können. Bevorzugte Bindemittel vom Styrol-Isopren-Typ enthalten in der Regel 10 bis 30 Gew.-%, bevorzugt 12 bis 28 Gew.-% und besonders bevorzugt von 14 bis 25 Gew.-% Styrol. Diese Blockcopolymere haben üblicherweise ein mittleres Molekulargewicht M_{w} (Gewichtsmittel) von 100 000 bis 300 000 g/mol. Selbstverständlich können auch Gemische verschiedener Styrol-Isopren-Blockcopolymere verwendet werden. In einer zweiten Ausführungsform der Erfindung können bevorzugt radiale Isopren-Styrol-Blockcopolymere eingesetzt werden.

Die Isopren-Einheiten in den Polyisopren-Blöcken können 1,4-verknüpft sein, d.h. die verbleibende Doppelbindung ist in der Kette angeordnet oder 3,4-verknüft, d.h. die verbleibende Doppelbindung ist seitenständig angeordnet. Es können Blockcopolymere eingesetzt werden, welche im Wesentlich 1,4-Verknüpfungen aufweisen und Bindemittel, welche gewisse Anteile an 3,4-Verknüpfungen aufweisen. Die seitenständigen Vinylgruppen in Bindemitteln mit 3,4-verknüpften Isopreneinheiten können im Zuge der Vernetzung der fotopolymersierbaren Schicht ebenfalls reagieren und können dementsprechend eine Platte mit hoher Vernetzung ergeben. Beispielsweise können Styrol-Isopren-Blockcopolymere eingesetzt werden, welche einen Vinylgruppengehalt von 20 bis 70 % aufweisen.

In einer bevorzugten Ausführungsform der Erfindung kann man ein radiales Styrol-Isopren-Copolymer einsetzen, welches einen Vinylgruppenanteil von weniger als 10 % aufweist. In einer zweiten bevorzugten Ausführungsform der Erfindung setzt man ein Gemisch von zwei verschiedenen Styrol-Isopren-Blockcopolymeren ein. Bevorzugt weist hierbei eines davon einen Vinylgruppengehalt von mindestens 20 % auf, insbesondere 20 bis 70 %, bevorzugt 25 bis 45 %. Das andere kann einen niedrigen Vinylgruppengehalt, beispielsweise einen von weniger als 10 % aufweisen. Weiterhin bevorzugt kann man ein Gemisch zweier Styrol-Isopren-Copolymerer einsetzen, von denen eines einen hohen Diblockanteil von mehr als 40 Gew.-% aufweist und das zweite einen niedrigeren Diblockanteil von 10 - 30 Gew.-%.

Neben den genannten thermoplastisch-elastomeren Blockcopolymeren, insbesondere den Styrol-Isopren-Blockcopolymeren kann die fotopolymerisierbare Schicht auch noch weitere, von den Blockcopolymeren verschiedene elastomere Bindemittel umfassen. Mit derartigen zusätzlichen Bindemitteln, auch sekundäre Bindemittel genannt, lassen sich die Eigenschaften der fotopolymerisierbaren Schicht modifizieren. Ein Beispiel für ein sekundäres Bindemittel sind Vinyltoluol-a-Methylstyrol-Copolymere. Im Regelfalle sollte die Menge derartiger sekundärer Bindemittel 25 Gew.-% bezüglich der Gesamtmenge aller eingesetzten Bindemittel nicht überschreiten. Bevorzugt übersteigt die Menge derartiger sekundärer Bindemittel nicht 15 Gew.%, besonders bevorzugt nicht 10 Gew.-%.

Die Gesamtmenge an Bindemitteln beträgt üblicherweise 40 bis 90 Gew.-% bezüglich der Summe aller Bestandteile der reliefbildenden Schicht, bevorzugt 50 bis 90 Gew.-% und besonders bevorzugt 60 bis 85 Gew.-%.

Die fotopolymerisierbare reliefbildende Schicht umfasst weiterhin mindestens ein ethylenisch ungesättigtes Monomer. Die eingesetzten Monomere sollten mit den Bindemitteln verträglich sein und weisen mindestens eine polymerisierbare, ethylenisch ungesättigte Gruppe auf. Als Monomere können insbesondere Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure und Allylverbindungen eingesetzt werden. Bevorzugt sind Ester der Acrylsäure oder Methacrylsäure. Bevorzugt sind 1,4-Butandioldiacrylat, 1,6-Hexandioldiacrylat, 1,6-Hexandioldimethacrylat, 1,9-Nonandioldiacrylat oder Trimethylolpropantri(meth)acrylat. Selbstverständlich können Gemische verschiedener Monomere eingesetzt werden.

Bevorzugt umfasst die reliefbildende Schicht mindestens ein ethylenisch ungesättigtes Monomer mit zwei ethylenisch ungesättigten Gruppen, insbesondere 1,6-Hexandioldiacrylat und/oder 1,6-Hexandioldimethacrylat.

Die Gesamtmenge aller Monomere in der reliefbildenden Schicht zusammen beträgt 1 bis 20 Gew.-%, bevorzugt 5 bis 20 Gew.-%, besonders bevorzugt 8 bis 20 Gew.-%, ganz besonders bevorzugt 8 bis 18 Gew.-% und beispielsweise 12 bis 18 Gew.-%, jeweils bezogen auf die Summe aller Bestandteile der reliefbildenden Schicht. Die Menge von Monomeren mit zwei ethylenisch ungesättigten Gruppen beträgt bevorzugt 5 bis 20 Gew.-%, bezogen auf die Summe aller Bestandteile der reliefbildenden Schicht, bevorzugt 8 bis 18 Gew.-%.

Die reliefbildende, fotopolymerisierbare Schicht umfasst weiterhin mindestens einen Fotoinitiator oder ein Fotoinitiatorsystem. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-%, bevorzugt 1 bis 4 Gew.-% und besonders bevorzugt 1,5 bis 3 Gew.-%, bezogen auf die Menge aller Bestandteile der reliefbildenden Schicht.

Daneben kann die reliefbildende, fotopolymerisierbare Schicht 1 bis 40 Gew.-%, bevorzugt 1 bis 20 Gew.-% Weichmacher enthalten. Weichmacher sind beispielsweise Polybutadienöle oder paraffinische oder naphthenische Mineralöle.

Im Falle einer thermisch entwickelbaren fotopolymerisierbaren Schicht kann es sich bei dem elastomeren Bindemittel beispielsweise um ein Styrol-Butadien-Blockcopolymer mit einem Molekulargewicht M_{w} von 80 000 bis 250 000 g/mol und einem Styrolgehalt von 15 bis 35 Gew. % bzgl. des Bindemittels handeln, wobei der Anteil von Butadien, welches 1,2-verknüpft vorliegt, mindestens 20 Gew. % bzgl. des Bindemittels beträgt, und die Menge des Styrol-Butadien-Blockcopolymeren 30 bis 50 Gew. % und die des Weichmachers 25 bis 50 Gew. % jeweils bezüglich der Summe aller Komponenten der fotopolymerisierbaren reliefbildenden Schicht beträgt.

Übliche fotopolymerisierbare Flexodruckelemente weisen darüber hinaus in der Regel eine dünne entklebende Schicht auf der fotopolymerisierbaren Schicht, häufig auch als "Substratschicht", aber auch als "Entklebungsschicht" oder "release layer" bezeichnet, sowie eine abziehbare Schutzfolie auf. Die entklebende Schicht soll das problemlose Abziehen einer Schutzfolie von der klebrigen Fotopolymerschicht sicherstellen, um eine Beschädigung der Oberfläche der fotopolymerisierbaren Schicht zu vermeiden und außerdem dafür sorgen, dass ein aufgelegtes fotografisches Negativ nicht mit der Oberfläche verklebt. Substratschichten können beispielsweise aus flexiblen Polyamiden bestehen. Die Flexodruckelemente können darüber hinaus eine Schutzfolie aufweisen. Zur Montage auf den Sleeve werden die fotopolymerisierbaren Flexodruckelemente zunächst auf die jeweils gewünschte Größe zurechtgeschnitten und können dann auf dem Sleeve befestigt werden. Dies kann beispielsweise mittels doppelseitigem Klebeband geschehen, mit dem der oben genannte dimensionsstabile Träger und der Sleeve verbunden werden. Alternativ kann der Sleeve beispielsweise mit einer Klebeschicht versehen werden.

Es ist ausreichend, dass die fotopolymerisierbaren Flexodruckelemente etwa an der richtigen Stelle montiert werden, ohne dass es hierbei auf absolute Präzision ankommt. Die ordnungsgemäße Registrierung wird im späteren Verfahren durch eine registergerechte digitale Bebilderung gewährleistet.

Um eine ordnungsgemäße Kantenabdeckung zu gewährleisten, hat es sich bewährt, zwischen den einzelnen Flexodruckelementen einen Abstand von mindestens 0,2 mm, bevorzugt 0,5 mm, beispielsweise 0,5 bis 2 mm zu lassen. Selbstverständlich können aber auch größere oder kleinere Abstände gewählt werden.

Selbstverständlich können auch fotopolymerisierbare Flexodruckelemente mit einem anderen Aufbau als dem oben geschilderten eingesetzt werden. So kann man beispielsweise Flexodruckelemente einsetzen, bei denen der dimensionsstabile Träger nicht fest mit der fotopolymerisierbaren Schicht verbunden ist, sondern abziehbar ist. Zur Montage wird die Basisfolie abgezogen, so dass die fotopolymerisierbare Schicht direkt mit dem Sleeve verbunden werden kann. Weiterhin können fotopolymerisierbare Flexodruckelemente eingesetzt werden, die keine Substratschicht aufweisen, oder solche, bei denen die Substratschicht fester an der Schutzfolie haftet als an der fotopolymerisierbaren Schicht, so dass beim Abziehen der Schutzfolie die Substratschicht mit abgezogen wird.

In Verfahrensschritt (a2) wird eine laserablatierbare, aktinisches Licht absorbierende Schicht auf die mit den fotopolymerisierbaren Flexodruckelementen versehene Oberfläche des Sleeves aufgesprüht.

Sofern die aufgebrachten Flexodruckelemente noch eine Schutzfolie aufweisen, muss die Schutzfolie vor Verfahrensschritt (a2) abgezogen werden. Eine eventuell vorhandene Entklebungsschicht kann auf dem Flexodruckelement verbleiben, so dass die laserablatierbare Schicht auf die Entklebungsschicht beschichtet wird. In einer bevorzugten Ausführungsform der Erfindung wird die laserablatierbare Schicht aber direkt auf die fotopolymerisierbare Schicht gesprüht. Sofern also noch eine Entklebungsschicht vorhanden ist, wird diese bei dieser Ausführungsform der Erfindung entfernt. Dies kann vorgenommen werden, indem man die Entklebungsschicht mit einem geeigneten Lösemittel abwäscht. Geeignete Lösemittel sollen die Entklebungsschicht möglichst gut lösen können, die fotopolymerisierbare Schicht hingegen möglichst nicht. Geeignete Lösemittel umfassen beispielsweise Alkohole wie Isopropanol oder andere Lösemittel ähnlicher Polarität.

Die laserablatierbare Schicht weist eine hohe Absorption im Wellenlängenbereich von 750 nm bis 20000 nm auf. Eine "hohe" Absorption bedeutet in diesem Zusammenhang, dass die Absorption im IR-Bereich so hoch ist, dass die Schicht bei Bestrahlung mit einem IR-Laser ablatiert werden kann. Die laserablatierbare Schicht weist weiterhin eine hohe Absorption im Bereich aktinischer Strahlung auf. Unter "aktinischer Strahlung" soll im üblichen Sinne "chemisch wirksames Licht" verstanden werden, durch welches die Fotopolymerisation der fotopolymerisierbaren Schicht bewirkt werden kann. Es handelt sich hierbei um UV-Strahlung, insbesondere UV-A-Strahlung oder UV-A-VIS-Strahlung. Die Absorption muss ausreichend sein um die Polymerisation der bedeckten fotopolymerisierbaren Schicht bei Bestrahlung zu verhindern oder zumindest weitgehend zu verhindern. Die laserablatierbare Schicht weist daher im Regelfalle im Bereich des aktinischen Lichts eine optische Dichte ≥ 2,0, bevorzugt ≥ 2,5 auf.

Zum Aufsprühen der laserablatierbaren Schicht wird eine Formulierung eingesetzt, welche mindestens ein Lösemittel, ein darin gelöstes polymeres Bindemittel sowie mindestens einen Absorber umfasst.

Bei dem Lösemittel kann es sich um Wasser oder ein organisches Lösungsmittel handeln. Selbstverständlich können auch Gemische verschiedener Lösemittel eingesetzt werden.

Bei den Bindemitteln kann es sich um wasserlösliche oder in organischen Lösemitteln lösliche Bindemittel handeln. Geeignete Bindemittel weisen gute filmbildende Eigenschaften auf und sollten bevorzugt elastomere Eigenschaften aufweisen. Beispiele umfassen Polyamide, Polyvinylalkohol oder auch thermisch zersetzliche Polymere wie Nitrocellulose. Selbstverständlich können auch Gemische verschiedener Polymere eingesetzt werden. Beispielsweise kann man ein Bindemittel mit guten filmbildenden Eigenschaften in Kombination mit einem thermisch zersetzlichen Bindemittel einsetzen.

Bei dem Absorber kann es sich um einen oder mehrere Absorber handeln, der sowohl im IR- als auch im Bereich des aktinischen Lichts absorbiert, oder aber es kann ein Gemisch aus einem oder mehreren Absorbern für IR-Strahlung und einem oder mehreren Absorbern für aktinisches Licht eingesetzt werden. Ein bevorzugter Absorber ist feinteiliger Ruß, beispielsweise Ruß mit einer durchschnittlichen Partikelgröße von 10 bis 50 nm, bevorzugt 10 bis 30 nm, der sowohl im IR- wie auch im UV-VIS-Bereich eine gute Absorption aufweist. Die Formulierung kann darüber hinaus selbstverständlich noch weitere Komponenten umfassen, wie beispielsweise Weichmacher oder Dispergierhilfsmittel. Beispiele geeigneter Formulierungen für laserablatierbare Schichten sind in EP-A 654 150 oder EP-A 1 069 475 offenbart.

Geeignete Binder sind beispielsweise thermisch zersetzliche Binder enthaltend Nitro- oder Nitrat-Gruppen. Beispiele für thermisch zersetzliche Binder sind Poly(glycidylazid), Poly(glycidylnitrat) und Poly(vinylnitrat). Weitere Beispiele umfassen Nitroderivate von Polystyrol, oder Derivate von Polyacrylaten oder Polymethacrylaten wie Polymere umfassend 2,4-Dinitrophenylacrylat oder p-Nitrophenylacrylat.

Von besonderer Bedeutung als thermisch zersetzliche Binder sind Nitrate von Cellulose oder Cellulosederivaten wie Celluloseethern. Cellulosenitrate, auch bekannt als Nitrocellulose, sind kommerziell erhältlich und weisen unterschiedliche Veresterungsgrade auf, wobei der maximale Substitutionsgrad drei Nitratgruppen pro Monomer betragen kann. Der Grad der Veresterung beeinflusst nicht nur die Zersetzungseigenschaften der Cellulosenitrate, sondern auch ihre Löslichkeitseigenschaften. Einige Typen sind gut löslich in Ester- oder Kohlenwasserstoff-Lösungsmitteln, während andere Typen gut in Alkoholen löslich sind.

Weitere geeignete Nitratester leiten sich von Celluloseethern wie Methylcellulose, Ethylcellulose, 2-Hydroxyethylcellulose, 2-Hydroxypropylcellulose oder Carboxymethylcellulose ab. Nitrierte Carboxymethylcellulose kann auch als Natriumsalz verwendet werden, wodurch die Wasserlöslichkeit des Binders erhöht wird. Es können auch Gemische von zwei oder mehr thermisch zersetzlichen Bindern verwendet werden. Im Allgemeinen beträgt die Menge des thermisch zersetzlichen Binders in der laserablatierbaren Schicht 20 bis 80 Gew.-%, vorzugsweise 30 bis 70 Gew.-%.

In einer Ausführungsform enthält die laserablatierbare Schicht als weitere Komponente einen aliphatischen Diester der allgemeinen Formel R¹(CO)[O-CHR³-CH₂]ₙO(CO)R². Diese Ester wirken als Weichmacher. Die Diester sind abgeleitet von Ethylenglykol, Propylenglykol und deren Oligomeren bzw. Polymeren. R³ ist H oder eine Methylgruppe, n kann von 1 bis 30 betragen, bevorzugt von 1 bis 10 und insbesondere von 2 bis 6. R¹ und R² sind geradkettige oder verzweigte Alkylreste mit 1 bis 20, vorzugsweise 5 bis 11 C-Atomen. Beispiele sind Triethylenglykol-Hexansäurediester, Triethylenglykol-2-Ethylhexansäurediester, Triethylenglykol-2-Ethylhexansäurediester und Triethylenglykol-Octansäurediester. Die Diester liegen in Mengen von im Allgemeinen 1 bis 30 Gew.-%, vorzugsweise 5 bis 20 Gew.-% in der laserablatierbaren Schicht vor.

Geeignete IR-lichtabsorbierende Materialien umfassen IR-absorbierende Farbstoffe wie Phthalocyanine und substituierte Phthalocyaninderivate, Cyaninfarbstoffe, Merocyaninfarbstoffe und Polymethin-Farbstoffe oder intensivfarbige anorganische Pigmente wie Eisenoxide oder Chromoxide, Ruß oder Graphit. Bevorzugter feinteiliger Ruß weist eine mittlere Teilchengröße von ≤ 30 nm auf und ist kommerziell erhältlich, beispielsweise als Printex^{®} U, Printex^{®} L6, Spezialschwarz 4 oder Spezialschwarz 250 von Degussa. Im Allgemeinen beträgt die Menge des IR-absorbierenden Materials in der laserablatierbaren Schicht von 1 bis 60 Gew.-%, vorzugsweise von 10 bis 50 Gew.-%, und insbesondere von 25 bis 50 Gew.-%.

Die laserablatierbare Schicht kann optional weitere Additive enthalten. Beispiele sind weitere polymere Binder, welche nicht unbedingt thermisch zersetzbar sein müssen, Dispergiermittel für Pigmente, Füllstoffe, Tenside und Beschichtungshilfsmittel. Es können weitere UV-absorbierende Materialien oder Farbstoffe mit verwendet werden. Additive sind im Allgemeinen in Mengen von bis zu 20 Gew.-%, vorzugsweise von bis zu 10 Gew.-%, in der laserablatierbaren Schicht enthalten. Alle Mengenangaben beziehen sich auf die Summe aller Komponenten der getrockneten laserablatierbaren Schicht.

Die Formulierung wird auf die mit den fotopolymerisierbaren Flexodruckelementen versehene Oberfläche des Sleeves gesprüht, und zwar so, dass sowohl die Oberflächen als auch die Kanten der aufgebrachten Flexodruckelemente besprüht werden. Es werden also die Flexodruckelemente einschließlich der Kanten mit einer laserablatierbaren Schicht versehen. Naturgemäß kann bei diesem Vorgang auch nicht von Flexodruckelementen bedeckte Oberfläche des Sleeves mit der Formulierung besprüht werden.

Die aufzusprühende Menge der Formulierung richtet sich hierbei nach der gewünschten Dicke der laserablatierbaren Schicht. Bewährt hat es sich, eine solche Menge aufzutragen, so dass die laserablatierbare Schicht nach dem Trocknen eine Dicke von 1 µm bis 10 µm, bevorzugt 3 µm bis 7 µm aufweist.

Das Aufsprühen kann prinzipiell mit jeder beliebigen Vorrichtung zum Versprühen von Formulierungen vorgenommen werden, beispielsweise, indem man die Formulierung mit einer von Hand zu bedienenden Sprühpistole versprüht.

In einer bevorzugten Ausführungsform setzt man zum Aufsprühen der Formulierung in Schritt (a2) eine Apparatur (I) ein, in der der Sleeve drehbar gelagert ist und von einer Antriebsvorrichtung in einer Rotationsbewegung versetzt wird. Die Vorrichtung weist weiterhin einen Sprühkopf auf, welcher auf die Oberfläche des drehbar gelagerten Sleeves gerichtet ist, wobei der Sprühkopf selbst so gelagert ist, dass er in Längsrichtung des Sleeves verschiebbar ist. Zum Verschieben in Längsrichtung verfügt die Apparatur (I) über einen entsprechenden Antrieb. Die Entfernung des Sprühkopfes von der Oberfläche des Sleeves beträgt in der Regel 5 bis 30 cm und kann mit einer entsprechenden Verstelleinrichtung eingestellt werden. Zum Aufsprühen der Formulierung versetzt man den Sleeve in eine Drehbewegung, während sich der Sprühkopf, welcher die besagte Formulierung versprüht, bevorzugt mit konstanter Geschwindigkeit in Längsrichtung von einem Ende des Sleeves zum anderen Ende des Sleeves bewegt. Durch die Kombination der Rotationsbewegung des Sleeves und der linearen Bewegung des Sprühkopfes wird der Sleeve in Art einer Schraubenbewegung vollständig mit der Formulierung beschichtet. Durch die Sprühtechnik dringt die Formulierung auch in enge Zwischenräume zwischen den Flexodruckelementen ein und deckt die Kanten ab. Die gewünschte Schichtdicke kann durch die Menge der pro Zeiteinheit versprühten Formulierung, die Drehgeschwindigkeit oder die Geschwindigkeit des Sprühkopfes eingestellt werden. Die Drehgeschwindigkeit kann an den jeweiligen Durchmesser des Sleeves angepasst werden.

Nach dem Aufbringen der Formulierung wird das Lösemittel verdampft, und eine getrocknete, mittels IR-Lasern ablatierbare und im Bereich des aktinischen Lichts absorbierende Schicht bleibt auf dem Sleeve zurück.

Der erhaltene Sleeve wird als Ausgangsmaterial für das weitere Verfahren eingesetzt, welches weitgehend dem üblichen Verarbeitungsverfahren fotopolymerisierbarer Sleeves entspricht.

In Schritt (b) werden zunächst Masken mithilfe eines IR-Lasers, beispielsweise eines Nd-YAG- oder CO₂-Lasers, in die laserablatierbaren Schichten der fotopolymerisierbaren Flexodruckelemente eingeschrieben. Hierzu geeignete Laser und Apparaturen sind dem Fachmann bekannt, beispielsweise aus DE 195 36 805 A1, insbesondere Seite 5, Zeilen 28 ff.. Es können auch Faserlaser, insbesondere Nd-YAG-Faserlaser eingesetzt werden.

In einer bevorzugten Ausführungsform setzt man zum Einschreiben der Masken eine Apparatur (II) ein, in der der Sleeve drehbar gelagert ist und von einer Antriebsvorrichtung in einer Rotationsbewegung versetzt wird. Die Vorrichtung weist weiterhin einen Laserkopf auf, welcher einen Laserstrahl auf die Oberfläche des drehbar gelagerten Sleeves richtet, wobei der Laser so gelagert ist, dass er in Längsrichtung des Sleeves verschiebbar ist. Bei dem Laser kann es sich beispielsweise um einen Nd-YAG-Laser, bevorzugt einen Nd-YAG-Faserlaser handeln. Zum Verschieben in Längsrichtung verfügt die Apparatur über einen weiteren, entsprechenden Antrieb. Zum Einschreiben der Masken versetzt man den Sleeve in eine Drehbewegung, während sich der Laserkopf bevorzugt mit konstanter Geschwindigkeit in Längsrichtung von einem Ende des Sleeves zum anderen Ende des Sleeves bewegt. Durch die Kombination der Rotationsbewegung des Sleeves und der linearen Bewegung des Laserkopfes kann der Laser die gesamte Oberfläche des Sleeves in Art einer Schraubenbewegung überstreichen. An den Stellen, die ablatiert werden sollen, lässt man den Laserstrahl auf die Oberfläche treffen, ansonsten wird er abgeschaltet bzw. mittels einer geeigneten Vorrichtung abgeblendet. Derartige Apparaturen (II) sind kommerziell erhältlich.

In Schritt (c) werden die fotopolymerisierbaren Schichten der Flexodruckelemente durch die in Schritt (b) gebildete Maske hindurch mit aktinischem Licht belichtet. Der Begriff "aktinisches Licht" wurde bereits definiert. Es können alle Arten von Strahlungsquellen für aktinisches Licht wendet werden, beispielsweise UV-Lampen, UV-Laser oder UV-Dioden bzw. UV-Diodenfelder (Dioden-Arrays). Im Zuge der Bestrahlung mit aktinischem Licht polymerisieren die von der Maske noch abgedeckten Bereiche der fotopolymerisierbaren Schicht nicht, während in den freigelegten Bereichen die fotopolymerisierbare Schicht polymerisiert wird.

Schritt (c) kann unter Verwendung üblicher Rundbelichter zum Belichten von Sleeves im Anschluss an Schritt (b) durchgeführt werden. Geeignete Geräte sind dem Fachmann bekannt.

In einer bevorzugten Ausführungsform der Erfindung kann die Durchführung von Schritt (c) mit Schritt (b) kombiniert werden. Die Schritte (b) und (c) werden hierbei unter Verwendung von nur einer Vorrichtung durchgeführt, welche sowohl zum Einschreiben einer Maske in die laserablatierbare Schicht als auch zum Belichten der Sleeves mit aktinischem Licht ausgestattet ist.

Zur kombinierten Ausführung der Schritte (b) und (c) setzt man bevorzugt eine Apparatur (II) ein, die zur Belichtung mit aktinischem Licht zusätzlich mit einer Vielzahl von UV-Dioden bzw. UV-Diodenfeldern ausgestattet ist. Mit ausreichender Intensität UV-Licht emittierende Dioden bzw. Diodenfelder sind kommerziell erhältlich.

In einer Ausführungsform der Erfindung können die UV-Dioden als Belichtungsleiste parallel zur Längsachse des Sleeves angeordnet werden, wobei die Belichtungsleiste sich mindestens über die gesamte Länge des Sleeves erstreckt. Es empfiehlt sich hierbei, die Belichtungsleiste auf der vom Laserkopf abgewandten Seite des Sleeves anzuordnen. Bei dieser Anordnung kann der Sleeve zunächst wie oben beschrieben ablatiert werden. Anschließend können die UV-Dioden eingeschaltet und der Sleeve bei weiter rotierendem Sleeve mit UV-Licht bestrahlt werden.

In einer weiteren Ausführungsform der Erfindung können die UV-Dioden ringförmig auf einem Träger in Form eines Ringes oder eines Ringabschnittes ganz oder teilweise um den Umfang des Sleeves herum angeordnet sein. Bevorzugt ist der ringförmige Träger in Längsrichtung des Sleeves mittels einer geeigneten Antriebsvorrichtung verschiebbar, so dass er wie der Laserkopf von einem Ende des Sleeves zum anderen Ende bewegt werden kann. Nach dem Einschreiben der Masken kann der mit UV-Dioden ausgestattete Träger bei eingeschalten UV-Dioden von einem Ende des Sleeves zum anderen bewegt werden und somit der Sleeve mit UV-Licht bestrahlt werden. Die Bestrahlung mit UV-Licht kann erfolgen, wenn die Masken vollständig, d.h. in der gesamten Länge in die Flexodruckelemente des Sleeves eingeschrieben sind, es ist aber bei dieser Anordnung der UV-Dioden auch möglich, mit der Belichtung durch die ringförmige Anordnung der Dioden an einem Ende des Sleeves zu beginnen, wenn die Laserablation in davon entfernteren Abschnitten noch läuft.

In einer bevorzugten Ausführungsform der Erfindung sind die UV-Dioden sowohl bei der leistenförmigen Anordnung als auch bei der ringförmigen Anordnung in einer Vielzahl von Diodenfeldern (Diodenarrays) angeordnet.

Weitere Einzelheiten zu derartigen Apparaturen zur kombinierten Ausführung der Laserablation und der UV-Belichtung sind in WO 2008/135865 A2 beschrieben. Entsprechende Geräte sind auch kommerziell erhältlich. Die kombinierte Ausführung bewirkt eine erhebliche Steigerung der Wirtschaftlichkeit des erfindungsgemäßen Verfahrens.

Nach dem Belichten werden in einem Schritt (d) die unbelichteten Bereiche der Flexodruckelemente, einschließlich der sich noch darauf befindlichen Reste der laserablatierbaren Schicht entfernt, während die belichteten, also vernetzten Bereiche erhalten bleiben. Hierdurch entsteht das Druckrelief.

Das Entfernen der unbelichteten Bereiche kann vorgenommen werden, indem man die unbelichteten Bereiche der Flexodruckelemente, einschließlich der sich noch darauf befindlichen Reste der laserablatierbaren Schicht mithilfe von geeigneten Lösemitteln bzw. Lösemittelgemischen auswäscht. Falls die laserablatierbare Schicht nicht im Entwickler löslich ist, wird sie gegebenenfalls vor dem Entwickeln mit Hilfe eines zweiten Lösemittels entfernt. Rundwascher für Sleeves sowie geeignete Lösemittel bzw. Lösemittelgemische sind dem Fachmann bekannt. Nach dem Auswaschen wird der Sleeve getrocknet.

Das Entfernen der unbelichteten Bereiche kann auch thermisch erfolgen. Bei der thermischen Entwicklung wird kein Lösemittel eingesetzt. Stattdessen wird die reliefbildende Schicht nach der Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Es wird auf eine solche Temperatur erwärmt, dass sich die nicht polymerisierten Anteile der reliefbildenden Schicht verflüssigen und vom Vlies aufgesogen werden können. Das vollgesogene Vlies wird anschließend entfernt. Einzelheiten zur thermischen Entwicklung sind beispielsweise von US 3,264,103, US 5,175,072, WO 96/14603 oder WO 01/88615 offenbart. Die Maske, also die Reste der laserablatierbaren Schicht kann gegebenenfalls vorher mittels eines geeigneten Lösemittels oder ebenfalls thermisch entfernt werden.

Die erhaltenen, zylinderförmigen Flexodruckformen können anschließend ohne weitere Nacharbeitung zum Flexodruck verwendet werden. Durch das erfindungsgemäße Verfahren werden alle Kanten auf einfache und elegante Art und Weise im Zuge des Aufbringens der laserablatierbaren Schicht bedeckt, so dass keine unerwünschten Stege beim Belichten entstehen. Zusätzliche Maßnahmen zum Kantenschutz sind nicht erforderlich. Gegenüber der bekannten Vorgehensweise wird somit ein aufwändiger Arbeitsschritt gespart und somit die Wirtschaftlichkeit der Plate-on-Sleeve-Technologie deutlich gesteigert.

## Patentansprüche

1. Verfahren zur Herstellung einer zylinderförmigen Flexodruckform umfassend auf einem zylinderförmigen Sleeve eine oder mehrere einzelne, voneinander beabstandete Flexodruckplatten, mit den Schritten:
(a) Bereitstellen eines Sleeves, auf dem eine oder mehrere einzelne fotopolymerisierbare Flexodruckelemente derart aufgebracht sind, dass zwischen den Kanten des oder der Flexodruckelemente Zwischenräume verbleiben, wobei das oder die Flexodruckelemente als oberste Schicht eine aktinisches Licht absorbierende, laserablatierbare Schicht aufweisen,
(b) Einschreiben einer Maske mittels eines IR-Lasers in die laserablatierbare Schicht der fotopolymerisierbaren Flexodruckelemente,
(c) Belichten der Flexodruckelemente durch die eingeschriebene Maske hindurch mit aktinischem Licht,
(d) Entfernen der nicht vernetzten, unbelichteten Bereiche der Flexodruckelemente und der Reste der laserablatierbaren Schicht,
**dadurch gekennzeichnet, dass** der in Schritt (a) bereitgestellte Sleeve mit den Flexodruckelementen hergestellt wird durch
(a1) Aufbringen eines oder mehrerer fotopolymerisierbarer Flexodruckelemente, wobei die Flexodruckelemente keine laserablatierbare Schicht aufweisen, auf den Sleeve derart, dass zwischen den Kanten des oder der Flexodruckelemente Zwischenräume verbleiben,
(a2) Aufsprühen der laserablatierbaren Schicht, enthaltend ein Lösemittel, ein darin gelöstes Bindemittel sowie mindestens einen Absorber oder ein Absorbergemisch für IR-Licht und aktinisches Licht, auf das oder die fotopolymerisierbaren Flexodruckelemente, wobei die Kanten der Flexodruckelemente von der laserablatierbaren Schicht bedeckt werden,
(a3) Trocknen der laserablatierbaren Schicht.

2. Verfahren nach Anspruch 1, **dadurch gekennzeichnet, dass** die laserablatierbare Schicht als Absorber für IR-Licht und aktinisches Licht feinteiligen Ruß mit einer durchschnittlichen Teilchengröße von 10 bis 50 nm enthält.

3. Verfahren nach Anspruch 1 oder 2, **dadurch gekennzeichnet, dass** die laserablatierbare Schicht nach dem Trocknen eine Dicke von 1 bis 10 Mikrometern aufweist.

4. Verfahren nach einem der Ansprüche 1 bis 3, **dadurch gekennzeichnet, dass** der Zwischenraum zwischen den Kanten der fotopolymerisierbaren Flexodruckelemente mindestens 0,5 mm beträgt.

5. Verfahren nach einem der Ansprüche 1 bis 4, **dadurch gekennzeichnet, dass** man zum Aufsprühen der laserablatierbaren Schicht in Schritt (a2) den Sleeve in Rotationsbewegung versetzt und einen Sprühkopf, der die in Schritt (a2) definierte Formulierung versprüht, in Längsrichtung von einem Ende des Sleeves zum anderen Ende des Sleeves bewegt.

6. Verfahren nach einem der Ansprüche 1 bis 5, **dadurch gekennzeichnet, dass** man in Schritt (b) den Sleeve in Rotationsbewegung versetzt und zum Einschreiben der Maske in die laserablatierbare Schicht einen Laserkopf, mit welchem ein IR-Laserstrahl auf die Oberfläche des Sleeves gerichtet werden kann, in Längsrichtung von einem Ende des Sleeves zum anderen bewegt.

7. Verfahren nach einem der Ansprüche 1 bis 6, **dadurch gekennzeichnet, dass** man Schritt (c) unter Verwendung eines Rundbelichters ausführt.

8. Verfahren nach einem der Ansprüche 1 bis 7, **dadurch gekennzeichnet, dass** man Schritt (c) mittels einer Vielzahl von UV-Dioden durchführt.

9. Verfahren nach Anspruch 8, **dadurch gekennzeichnet, dass** die UV-Dioden als Belichtungsleiste parallel zur Längsachse des Sleeves angeordnet sind und die Belichtungsleiste sich mindestens über die gesamte Länge des Sleeves erstreckt.

10. Verfahren nach Anspruch 8, **dadurch gekennzeichnet, dass** die UV-Dioden auf einem Träger in Form eines Ringes oder eines Ringabschnittes ganz oder teilweise um den Umfang des Sleeves herum angeordnet sind, und man die UV-Dioden mit dem Träger nach dem Einschreiben der Maske in die laserablatierbare Schicht in Längsrichtung zum Sleeve bewegt.

11. Verfahren nach einem der Ansprüche 8 bis 11, **dadurch gekennzeichnet, dass** die UV-Dioden in einer Vielzahl von Diodenfeldern angeordnet sind.

12. Verfahren nach einem der Ansprüche 1 bis 11, **dadurch kennzeichnet, dass** man Schritt (d) durchführt, indem man die unbelichteten Bereiche der Flexodruckelemente sowie die Reste der laserablatierbaren Schicht mittels eines Lösemittels bzw. eines Lösemittelgemisches entfernt.

13. Verfahren nach einem der Ansprüche 1 bis 12, **dadurch kennzeichnet, dass** man Schritt (d) durchführt, indem man die unbelichteten Bereiche der Flexodruckelemente sowie die Reste der laserablatierbaren Schicht durch thermische Behandlung entfernt.
